# EUROPEAN PATENT APPLICATION

(11) **EP 4 723 090 A1**
(43) Date of publication of application: **08.04.2026**
(21) Application number: 23751524.2
(22) Date of filing: 09.06.2023
(51) Int. Cl.: G09G 3/36, G11C 19/28

(54) **SEMICONDUCTOR DEVICE AND DISPLAY PANEL**

(30) Priority: 31.05.2023 CN 202310650016
(71) Applicant: Wuhan China Star Optoelectronics Technology Co., Ltd., Wuhan, Hubei 430079 (CN)
(72) Inventor: GE, Ning, Wuhan, Hubei 430079 (CN); TIAN, Chao, Wuhan, Hubei 430079 (CN); AI, Fei, Wuhan, Hubei 430079 (CN)
(74) Representative: Murgitroyd & Company
(86) International application number: PCT/CN2023/099531
(87) International publication number: WO 2024/244049

(57) **Abstract**

The present disclosure provides a semiconductor device and a display panel, the semiconductor device includes an insulating substrate, at least one data input terminal, and a plurality of clock lines. By dividing a plurality of shift registers into a plurality of shift register groups, each clock line of the plurality of clock lines controls a rate of a shift register group, and compared with the case of controlling all of the shift registers through a single clock line, a rate of the shift register may be easily increased to a higher value as frequencies of a plurality of clock signals increase.

## Description

### TECHNICAL FIELD

The present disclosure relates to a field of display technologies, and more particularly, to a semiconductor device and a display panel.

### BACKGROUND

With the rise of 5G, Internet of Things (IoT), automotive industries, and the like, a demand for a silicon-based integrated circuit (IC) is increasing. In addition, the cost of chips is expensive, the lack of chips or the reduction of the amount of chips core may continue.

In a display panel, a source driver for providing a data signal generally exists in the form of a chip, however, a rate of the source driver is limited by a bottleneck and difficult to improve.

### SUMMARY

The present application provides a semiconductor device and a display panel to alleviate a technical problem that a rate of a source driver is limited by a bottleneck and is difficult to improve.

According to a first aspect, the present disclosure provides a semiconductor device including an insulating substrate, at least one data input terminal, and a plurality of clock lines. The insulating substrate includes a source driver. The source driver includes a plurality of shift register groups, each shift register group includes a plurality of shift registers, and each of the shift registers is electrically connected to a corresponding pixel circuit through a data line. The at least one data input terminal is electrically connected to a first stage shift register of each of the plurality of shift register groups. Each of the plurality of clock lines is electrically connected to each shift register in a same one of the plurality of shift register groups.

In some embodiments, the plurality of clock lines are configured to transmit a plurality of clock signals having a same frequency and different phases respectively.

In some embodiments, the shift registers of the plurality of shift register groups are arranged alternately in sequence.

In some of these embodiments, a clock line of the plurality of clock lines for transmitting a clock signal with a more delayed phase is electrically connected to a shift register group of the plurality of shift register groups arranged further back.

In some embodiments, the plurality of shift register groups includes a first shift register group and a second shift register group, and the at least one data input terminal is electrically connected to the first shift register group and the second shift register group. The plurality of clock lines includes a first clock line and a second clock line, the first clock line is electrically connected to one of the first shift register group or the second shift register group, and the second clock line is electrically connected to another of the first shift register group or the second shift register group.

In some embodiments, the plurality of shift register groups includes a first shift register and a second shift register arranged alternately in sequence, the first shift register group includes the first shift register, and the second shift register group includes the second shift register. The first clock line is electrically connected to the first shift register group, the second clock line is electrically connected to the second shift register group, the first clock line is configured to transmit a first clock signal, the second clock line is configured to transmit a second clock signal, and a phase of the second clock signal is delayed from a phase of the first clock signal.

In some embodiments, a frequency of the first clock signal is the same as a frequency of the second clock signal, and a difference between the phase of the first clock signal and the phase of the first clock signal is 180°.

In some embodiments, the source driver further includes signal processing modules, an input terminal of each of the signal processing modules is electrically connected to an output terminal of a shift register of the shift registers, and each of the signal processing modules outputs a corresponding data signal.

In some embodiments, each of the signal processing modules includes a latch, a level converter, a digital-to-analog converter, and an amplifier that is electrically connected in sequence, an input terminal of the latch is electrically connected to an output terminal of the shift register, a trigger terminal of the latch is electrically connected to a data enable line, and the amplifier is configured to output a corresponding data signal.

In some embodiments, at least one of the at least one data input terminal and the plurality of clock lines is disposed in the insulating substrate.

According to a second aspect, the present disclosure provides a display panel including the semiconductor device of at least one embodiment described above, and a data input terminal is used for transmitting a digital signal.

### Beneficial effect

According to the semiconductor device and the display panel provided in the present disclosure, a plurality of shift registers are divided into a plurality of shift register groups, and each clock line of the plurality of clock lines controls a rate of a shift register group. Compared with the case of controlling the shift registers through a single clock line, it is possible not only to achieve a rate through a plurality of clock signals at a lower frequency in the plurality of clock lines, which is the same as the rate achieved by controlling all the shift registers through a single clock line, but also to have a larger improving space because the frequency of the plurality of clock signals in the plurality of clock lines decreases. Therefore, the rate of the shift register may be easily increased to a higher value with the increase of the frequency of the plurality of clock signals, thereby increasing the rate of the source driver.

In addition, the source driver may be integrated in the insulating substrate in the form of a non-chip, which not only alleviates the tight requirements of the silicon-based integrated circuit, but also reduces the cost of the source driver, thereby reducing the manufacturing cost of the semiconductor device or the display panel.

### BRIEF DESCRIPTION OF FIGURES

FIG. 1 is a schematic diagram of a first structure of a source driver according to the related art.
FIG. 2 is a waveform simulation diagram of signals related to FIG. 1.
FIG. 3 is a schematic diagram of a second structure of a source driver according to the related art.
FIG. 4 is a schematic diagram of a first structure of a semiconductor device according to an embodiment of the present application.
FIG. 5 is a waveform simulation diagram of signals related to FIG. 4.
FIG. 6 is a schematic diagram of a second structure of a semiconductor device according to an embodiment of the present application.
FIG. 7 is a schematic structural diagram of a display panel according to an embodiment of the present application.

### DETAILED DESCRIPTION

In order to make the objects, technical solutions, and effects of the present disclosure clearer and more explicit, the present disclosure will be described in further detail below with reference to the accompanying drawings and embodiments. It is to be understood that the specific embodiments described herein are merely illustrative of the present disclosure and are not intended to limit the present disclosure.

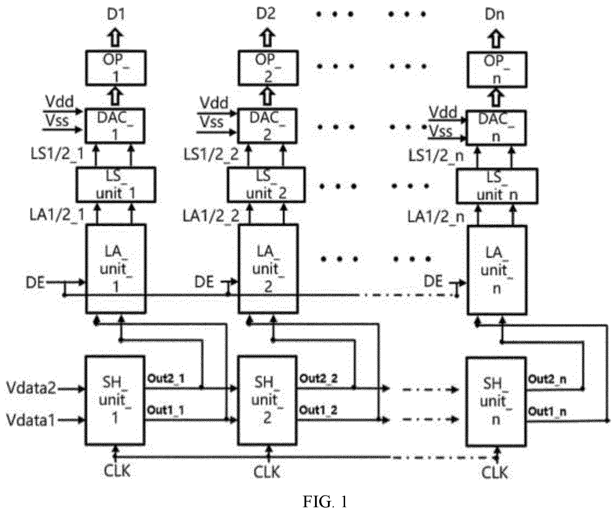

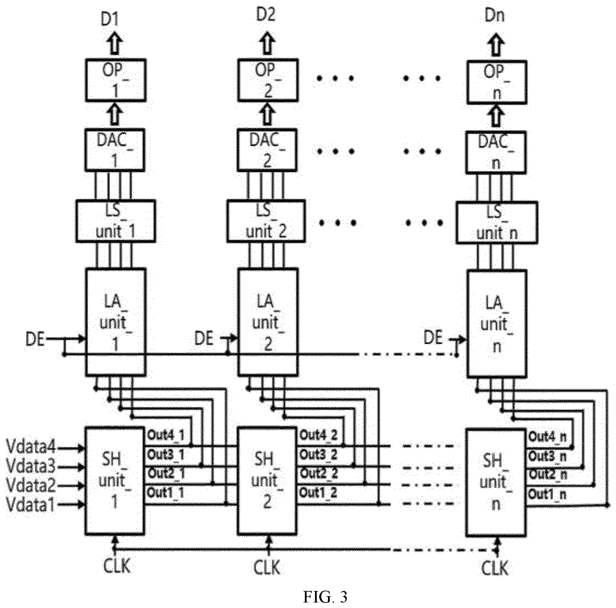

The source drivers in FIGS. 1 and 3 are both integrated circuits formed on a silicon substrate, and in the source drivers, data signals (D1, D2...DN) required by a pixel array in a display region are finally generated by electrically connecting shift registers (SH_unit_1, SH_unit_2, ... , SH_unit_n), latches (LA_unit_1, LA_unit_2, ... , LA_unit_n), level conversion circuits or level converters (LS_unit_1, LS_unit_2, ... , LS_unit_n), analog-to-digital converters (DAC_1, DAC_2, ... , DAC_n), and amplifiers (OP_1, OP_2, ... , OP_n) in turn.

In fact, the source driver is a circuit for generating at least one gray-scale data signal. Taking a 2-bit digital signal (Vdata1, Vdata2) shown in FIG. 1 as an example, a 4-gray-scale data signal may be generated. The operation principle is as follows: the 2-bit digital signal, i.e., binary picture information, is input in parallel, and through the shift of clock signal CLK, the Vdata1, Vdata2 are shifted by a first stage shift register SH_unit_1 to obtain output signals Out1_1, Out2_1; the output signals Out1_1, Out2_1 are both input to a latch LA_unit_1 and are used as input signals of a second stage shift register SH_unit_2, output signals Out1_2, Out2_2 are obtained through the shift of the second stage shift register SH_unit_2, and so on, and the output signals are shifted level by level, until a n-th stage shift register SH_unit_n provides output signals Out1_n, Out2_n.

The 4-bit digital signal (Vdata1, Vdata2, Vdata3, and Vdata4) shown in FIG. 3 may be used as an example to generate a 16-gray-scale data signal. The operation principle is as follows: the 4-bit digital signal, i.e., binary picture information, is input in parallel, and through the shift of clock signal CLK, the Vdata1, Vdata2, Vdata3, and Vdata4 are shifted by a first stage shift register SH_unit_1 to obtain the output signals Out1_1, Out2_1, Out3_1, and Out4_1; the output signals Out1_1, Out2_1, Out3_1, and Out4_1 are input to a latch LA_unit_1 and are used as input signals of a second stage shift register SH_unit_2, output signals Out1_2, Out2_2, Out3_2, and Out4_2 are obtained through the shift of the second stage shift register SH_unit_2, and so on, and the output signals are shifted level by level, until a n-th stage shift register SH_unit_n provides output signals Out1_n, Out2_n, Out3_n, and Out4_n.

Digital signals with other bits may be derived by analogy.

Thereafter, the states of the two output signals supplied from each stage shift register are identified by a data enable signal(s) DE, and the latches (LA_unit_1, LA_unit_2, ... , LA_unit_n ) are controlled to start working simultaneously. The output signal of the latch is then boosted by the level converter, because the shift register and the latches are digital modules and a voltage difference requirement is small, but the signals are then converted into analog signals, and the voltage difference requirement is large. The signals are then input to each subsequent analog-to-digital converter at the same time to convert the digital signal into an analog signal required for a pixel. Finally, the amplifiers output data signals (D1, D2, ... , DN).

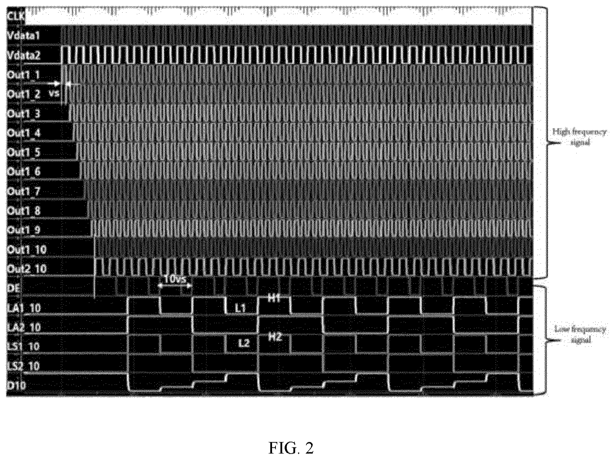

The operation timing of the source driver in FIG. 1 is shown in FIG. 2. Taking 10 data signals as an example, it is assumed that a period of the clock signal CLK, that is, CLK _T, is vs (vs is one time unit of the order of us/ns or less), and the periods of the Vdata1 and Vdata2, that is, Vdata1_T and Vdata2_T, are sequentially 2vs and 4vs, respectively, where Vdata1 and Vdata2 are parallel inputs.

In FIG. 2, it is fully shown a process that the Vdata1 is shifted in 10 stages, i.e., from Out1_1 to Out1_10, Outl_2 delays vs compared to Out1_1, and so on, the completion time of the Vdata1 for the shift of 10 stages is 10vs. The shift principle of Vdata2 is the same as that of Vdata1, and the process of the shift of 10 stages for Vdata2 may be omitted in the timing figure and deduced from the above process of Vdata1.

As mentioned above, the data enable signal DE may only function after the output signals are supplied from the shift registers of various stages. Therefore, the period of the data enable signal DE in the timing is 10Vs, and the start time of the data enable signal DE is the same as the start times of the Out1_10 and the Out2_10. Since the subsequent latches, level converters, digital-to-analog converters, and amplifiers are all running in parallel, the data signal D10 output from the tenth stage shift register is taken as an example for illustration in the timing, each latch is triggered in response to the rising edge of the data enable signal DE (the operation principle of the D flip-flop), and the Out1_10 and Out2_10 are processed by the latch LA_unit_10 to output low-frequency 2-bit digital signals LA1_10 and LA2_10, where L1 is a low potential of LA1_10, H1 is a high potential of LA1_10, and H2>H1 and L2<L1. The signals LA1_10 and LA2_10 are then boosted by the level converter LS_unit_10 to obtain LS1_10 and LS2_10. Finally, the LS1_10 and LS2_10 are processed by a digital-to-analog converter DAC_10 (not shown) and an amplifier OP_10 (not shown) to obtain a data signal D10 of an analog type and having a 4-gray-scale voltage.

It should be noted that the amplifier OP_10 is used to enhance the output capability, the data signal D10 has been generated in the digital-to-analog converter DAC_10, and the digital-to-analog converter is a linear voltage division type digital-to-analog converter, a minimum voltage of which is a potential of a negative signal Vss of the power supply, and a maximum voltage of which is a potential of a positive signal Vdd of the power supply.

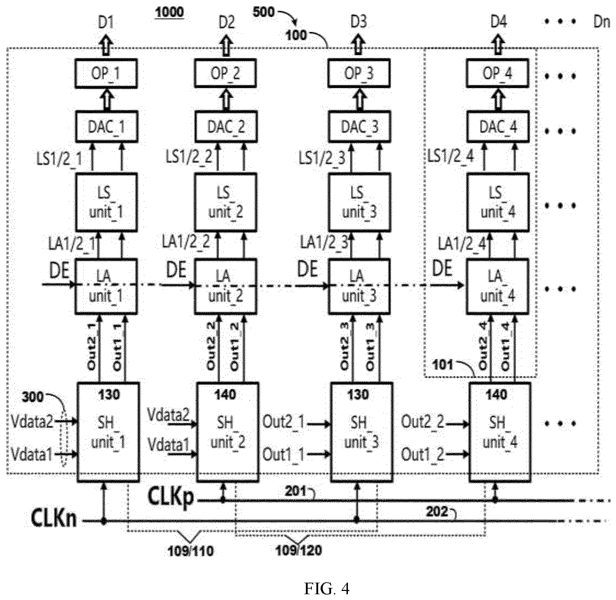

The operation of the source driver shown in FIG. 3 is similar to that of the source driver shown in FIG. 1, except that the source driver shown in FIG. 1 receives a two-bit digital signal, so that the signal processed during the modulation of each data signal and before the analog-to-digital converter receives it is also the two-bit digital signal, however, the source driver shown in FIG. 4 receives a four-bit digital signal, so that the signal processed during the modulation of each data signal and before the analog-to-digital converter receives it is also the four-bit digital signal.

On the basis of the above-mentioned operating principle for generating the data signal, it can be seen that the key to the speed or rate bottleneck of the source driver is the shift register, the input signal (Vdata) is shifted by n stages before it is processed in the latch, and the number of stages of the shift register is related to the number of columns of pixels in the display panel. Therefore, the display panel needs a higher resolution or refresh rate, and the speed of the single stage shift register also needs to be faster, that is, the frequency of the clock signal CLK needs to be higher and higher until the clock signal CLK becomes a high frequency signal of which the frequency cannot be increased.

However, there are two problems, one is that the high-frequency clock signal CLK is susceptible to loading, and with higher the resolution of the display panel, the greater the number of stages of the shift register, and the clock signal CLK is easily distorted due to the large loading in the process of transmitting to the remote shift register, resulting in an abnormal output of the tail stage shift register. Another problem is that the rate of the glass-based transistor is lower than the rate of the silicon-based transistor, and the operating speed of the shift register under the high-frequency clock signal CLK is difficult to increase.

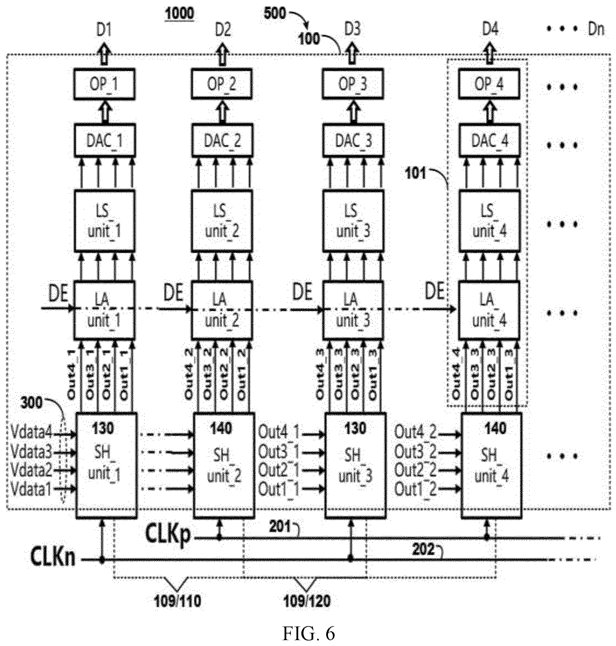

Therefore, in view of the above-mentioned technical problem that the rate of the source driver is difficult to improve due to the bottleneck, the present embodiment provides a semiconductor device 1000. Referring to FIGS. 4 to 7, as shown in FIGS. 4 and 6, the semiconductor device 1000 includes at least one of an insulating substrate 500, at least one data input terminal 300, and a plurality of clock lines.

The insulating substrate 500 includes a source driver 100 including a plurality of shift register groups 109, each shift register group 109 includes one or more shift registers.

At least one data input terminal 300 is electrically connected to a first stage shift register of each of the shift register groups 109.

Each of the clock lines is electrically connected to each shift register in the same shift register group 109.

It will be appreciated that in the semiconductor device 1000 provided in the present embodiment, by dividing a plurality of shift registers which are sequentially connected (an output terminal of a last shift register is not connected to an output terminal of a first shift register) into a plurality of shift register groups 109, each of the plurality of clock lines controls a rate of a corresponding one of the shift register groups 109. Compared with the case of controlling a plurality of shift registers, which are connected sequentially, by a single clock line, it is possible not only to achieve a rate through a plurality of clock signals at a lower frequency in the plurality of clock lines, which is the same as the rate achieved by controlling all the shift registers through a single clock line, but also to have a larger improving space because the frequency of the plurality of clock signals in the plurality of clock lines decreases. Therefore, the rate of the shift register may be easily increased to a higher value with the increase of the frequency of the plurality of clock signals, thereby increasing the rate of the source driver 100.

In addition, the source driver 100 may be integrated in the insulating substrate 500 in the form of a non-chip, which not only alleviates the tight requirements of the silicon-based integrated circuit, but also reduces the cost of the source driver 100 and improves the utilization rate of the insulating substrate 500, thereby reducing the manufacturing cost of the semiconductor device 1000 or the display panel.

In the case where there are a plurality of shift registers in the same shift register group 109, the plurality of shift registers are sequentially connected, that is, in one shift register group 109, an input terminal of the first shift register is connected to the at least one data input terminal 300, an output terminal of the first shift register is connected to an input terminal of the second shift register, an output terminal of the second shift register is connected to an input terminal of the third shift register, and so on.

It should be noted that the data input terminal is used to transmit a digital signal, for example, Vdata1 and Vdata2 shown in FIG. 4, or Vdata1, Vdata2, Vdata3, and Vdata4 shown in FIG. 6. The number of shift register groups 109 is the same as the number of clock lines. The plurality of shift register groups 109 may be two, three or more integer shift register groups 109. The plurality of clock lines may also be two, three or more clock lines.

In an embodiment, the plurality of clock lines are used to transmit a plurality of clock signals having the same frequency and different phases.

It should be noted that in the present embodiment, since the phases of the clock signals are different, the shift registers in the different shift register groups 109 can be controlled to sequentially supply corresponding output signals as required.

In an embodiment, the shift registers in the plurality of shift register groups 109 are arranged alternately in sequence.

It should be noted that in the present embodiment, the shift registers in the plurality of shift register groups 109 are arranged alternately in sequence, so that it is advantageous to control the shift registers in the different shift register groups 109 to provide corresponding output signals in sequence as required.

In an embodiment, a clock line transmitting a clock signal with a more delayed phase is electrically connected to a shift register group 109 arranged further back. Alternatively, clock lines transmitting clock signals of which phases are delayed in sequence are electrically connected sequentially to the shift register groups 109 arranged sequentially backwards in which the shift registers are arranged.

It should be noted that in the present embodiment, various shift registers in different shift register groups 109 may be further controlled to provide corresponding output signals in sequence as required.

In an embodiment, as shown in FIG. 4, the plurality of shift register groups 109 include a first shift register group 110 and a second shift register group 120, and at least one data input terminal 300 is electrically connected to the first shift register group 110 and the second shift register group 120. The plurality of clock lines include a first clock line 202 and a second clock line 201, the first clock line 202 is electrically connected to one of the first shift register group 110 or the second shift register group 120, and the second clock line 201 is electrically connected to another of the first shift register group 110 or the second shift register group 120.

It should be noted that the at least one data input terminal 300 may synchronously provide the corresponding digital signals, for example, Vdata1 and Vdata2, for the shift register groups 109 to generate data signals corresponding to gray scales.

In an embodiment, the plurality of shift register groups 109 includes a first shift register 130 and a second shift register 140 arranged alternately in sequence, the first shift register group 110 includes the first shift register 130, and the second shift register group 120 includes the second shift register 140. The first clock line 202 is electrically connected to the first shift register group 110, the second clock line 201 is electrically connected to the second shift register group 120, the first clock line 202 is used to transmit the first clock signal CLKn, the second clock line 201 is used to transmit the second clock signal CLKp, and the phase of the second clock signal CLKp is delayed from the phase of the first clock signal CLKn.

It should be noted that, in the present embodiment, the frequency of the first clock signal CLKn and the frequency of the second clock signal CLKp may be lower than the frequency of the clock signal shown in FIG. 2. Therefore, when the source driver 100 needs a higher rate, since the frequency of the first clock signal CLKn and the frequency of the second clock signal CLKp have a larger improving space, the rate of the source driver 100 also has a larger improving space.

The first shift register 130 may be at least one of a first stage shift register SH_unit_1 and a third stage shift register SH_unit_3, ... , a (2n-1)-th stage shift registers SH_unit_2n-1. The second shift register 140 may be at least one of a second stage shift register SH_unit_2 and a fourth stage shift register SH_unit_4, ... , a 2n-th stage shift registers SH_unit_2n.

The first shift registers 130 and the second shift registers 140 may be arranged alternately in sequence in the direction from left to right. Each of the first shift registers 130 is distributed in an odd column, and each of the second shift registers 140 is distributed in an even column.

In an embodiment, the frequency of the first clock signal CLKn is the same as the frequency of the second clock signal CLKp, and a difference between the phase of the first clock signal CLKn and the phase of the first clock signal CLKn is 180°.

It should be noted that, in the present embodiment, the frequency of the first clock signal CLKn and the frequency of the second clock signal CLKp may be reduced to half the frequency of the clock signal shown in FIG. 2. Therefore, when the source driver 100 needs a higher rate, since the frequency of the first clock signal CLKn and the frequency of the second clock signal CLKp have a larger improving space, the rate of the source driver 100 also has a larger improving space. The difference between the phase of the first clock signal CLKn and the phase of the first clock signal CLKn is 180°. Specifically, the phase of the second clock signal CLKp is delayed relative to the phase of the first clock signal CLKn, so that the data signals D1, D2, D3, D4, ... , Dn outputs pulses for charging successively in the same frame.

In an embodiment, as shown in FIG. 4, the source driver 100 further includes signal processing modules, an input of each signal processing module is electrically connected to an output of a corresponding shift register, and each signal processing module outputs a corresponding data signal.

It should be noted that, in the present embodiment, the signal processing module may be used to convert the output signal of the shift register into a data signal required for a pixel.

In an embodiment, as shown in FIG. 4, the signal processing module includes a latch, a level converter, a digital-to-analog converter, and an amplifier electrically connected in sequence, an input of the latch is electrically connected to the output of the shift register, a trigger side of the latch is electrically connected to a data enable line, and the amplifier is used for outputting a corresponding data signal.

It is to be noted that the specific operation principle of the present embodiment may be described with reference to the foregoing description in relation to FIG. 1. The data enable line is used to transmit the data enable signal DE.

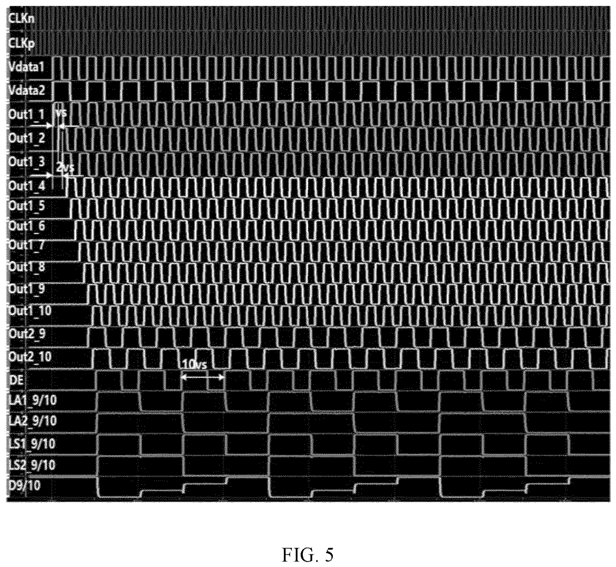

It is to be noted that compared with FIG. 2, in FIG. 5, only the clock signal CLK in FIG. 2 is divided into two parallel clock signals, that is, a first clock signal CLKn and a second clock signal CLKp, the frequency of the first clock signal CLKn and the frequency of the second clock signal CLKp are both half the frequency of the clock signal CLK.

It is assumed that one period of the clock signal CLK is T, the total number of shift registers is n (the n data signals, such as D1/2, ... , n, required by the pixel array in the display panel), the first clock signal CLKn has the same period as that of the second clock signal CLKp, the phase of the first clock signal CLKn is opposite to that of the second clock signal CLKp, two sets of stage transmission parts (such as a set of stage transmission part of the first register group and a set of stage transmission part of the second register group) use a group of input signals Vdata1, Vdata2, the first clock signal CLKn is responsible for the stage transmission of odd-number-th stage shift registers, such as SH_unit_1/3/5, ... , n-1, the output signal Out1/2_1 of SH_unit_1 of is a input signal of SH_unit_3; the second clock signal CLKp is responsible for the stage transmission of even-number-th stage shift registers, such as SH_unit_2/4/6...n, and the time (t) to complete the final shift of n stages is unchanged, previously t=nT in FIG. 2, and now t= (n/2)*2T=nT in FIG. 5. In such a case, the frequency of the first clock signal CLKn and the frequency of the second clock signal CLKp are lower than the frequency of the clock signal CLK, the first clock signal CLKn and the second clock signal CLKp are less affected by loading, and the number of stages of shift for the first clock signal CLKn and the second clock signal CLKp is less, so that the two problems faced by the shifts of multiple stages for the clock signal CLK in FIG. 1 may be well solved. After the shift is completed, the subsequent operation of the signal processing module may be consistent with the related description of FIG. 1.

The operation of the source driver 100 in the above-described embodiment is shown in FIG. 5, still taking 10 data signals as an example, the clock signal CLK with the period vs in FIG. 2 is downconverted into a first clock signal CLKn and a second clock signal CLKp, which are opposite in phase and have a period 2vs, the first clock signal CLKn is responsible for the stage transmission of the odd-number-th stage shift registers, the second clock signal CLKp is responsible for the stage transmission of the even-number-th stage shift registers, and a period of Vdata1 (i.e., Vdata1_T) and a period of Vdata2 (i.e., Vdata2_T) are 4vs, 8vs, respectively. The Vdata1 and the Vdata2 are respectively inputted in parallel to the first shift register in the first register group and the first shift register in the second register group.

FIG. 5 shows a complete process in which the Vdata1 is shifted by ten stages. Unlike FIG. 2, the Vdata1 is shifted by five stages in parallel by the first clock signal CLKn and the second clock signal CLKp respectively, to complete the operation of the shift registers of ten stages in FIG. 1. That is, the shifts of five stages performed though the five shift registers (such as SH_unit_1, SH_unit_3, ... , SH_unit_9, and so on) of the first shift register group 110 sequentially-connected, and the shifts of five stages performed though the five shift registers (such as SH_unit_2, SH_unit_4, ... , SH_unit_10) of the second shift register group 120 sequentially-connected may occur in parallel. Out1_3 is delayed by 2vs compared to Out1_1, and Out1_4 is delayed by 2vs compared to Out1_2, so that the time for completing the shifts of 10 stages is still 10vs=5*2vs. Since the phase of the second clock signal CLKp is opposite to the phase of the first clock signal CLKn, it can be considered that the phase of the second clock signal CLKp is delayed by vs compared to the phase of the first clock signal CLKn, and the Out1_1 is still delayed by vs compared to Out1_2, which is consistent with FIG. 2.

FIG. 5 shows the intermediate timing of the latches LA_9/10 and the level converters LS_9/10, and the fourth-gray-scale data signals D9, D10. It can be seen that the parallel manner of the first clock signal CLKn and the second clock signal CLKp does not change the frequency of the generated data signal, but the high-rate shift register is slower in the frequency and is not prone to be affected by the loading. On the other hand, it is possible to break through the rate bottleneck of the glass-based device by using two lower frequency clock signals (i.e., the first clock signals CLKn and the second clock signal CLKp) to realize the function of one clock signal CLK with higher frequency.

It should be noted that the operation of the source driver shown in FIG. 6 is similar to the operation of the source driver shown in FIG. 4, except that the source driver shown in FIG. 4 receives a two-bit digital signal, so that the signal processed during the modulation of each data signal and before the analog-to-digital converter receives it is also the two-bit digital signal, however, the source driver shown in FIG. 6 receives a four-bit digital signal, so that the signal processed during the modulation of each data signal and before the analog-to-digital converter receives it is also the four-bit digital signal.

In an embodiment, at least one of the at least one data input terminal 300 and the plurality of clock lines is disposed in the insulating substrate 500.

It should be noted that in the present embodiment, at least one of the at least one data input terminal 300 and the plurality of clock lines is provided in the insulating substrate 500, so that not only the original space occupied by these hardware in the semiconductor device 1000 can be saved, but also the utilization rate of the insulating substrate 500 can be further improved.

In an embodiment, the present embodiment provides a display panel including the semiconductor device 1000 in at least one of the embodiments described above.

It may be appreciated that since the display panel provided in the present embodiment includes the semiconductor device 1000 in the at least one of the embodiments described above, it is likewise possible to divide a plurality of shift registers into a plurality of shift register groups 109, each clock line of the plurality of clock lines controls the rate of one corresponding shift register group 109. Compared with the case of controlling a plurality of shift registers by a single clock line, it is possible not only to achieve a rate through a plurality of clock signals at a lower frequency in the plurality of clock lines, which is the same as the rate achieved by controlling all the shift registers through a single clock line, but also to have a larger improving space because the frequency of the plurality of clock signals in the plurality of clock lines decreases. Therefore, the rate of the shift register may be easily increased to a higher value with the increase of the frequency of the plurality of clock signals, thereby increasing the rate of the source driver 100.

In addition, the source driver 100 may be integrated in the insulating substrate 500 in the form of a non-chip, which not only alleviates the tight requirements of the silicon-based integrated circuit, but also reduces the cost of the source driver 100, thereby reducing the manufacturing cost of the semiconductor device 1000 or the display panel.

It should be noted that the display panel further includes a plurality of data lines, each of which is electrically connected to an output terminal of a shift register to transmit a corresponding data signal to a pixel.

The display panel may be, but is not limited to, a liquid crystal display panel, or may be a self-light-emitting display panel.

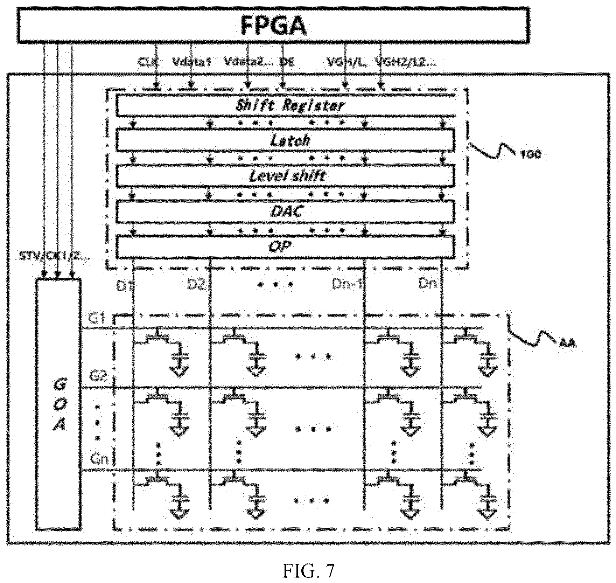

As shown in FIG. 7, the display panel further includes a gate driving circuit (or gate on array, GOA), an array of pixels in the display area AA, an external power supply, and a field programmable gate array (FPGA) that provides desired input signals.

Here, the gate driving circuit is also integrated in the semiconductor device 1000 or the display panel in the form of a non-chip, which further reduces the requirement of the chip and reduces the cost.

It may be understood that, for those ordinary skilled in the art, equivalent replacements or changes can be made according to the technical solutions and inventive concepts of the present disclosure, and all such changes or replacements should fall within the protection scope of the claims appended to the present disclosure.

## Claims

1. A semiconductor device comprising:
an insulating substrate comprising a source driver, wherein the source driver comprises a plurality of shift register groups, each of the plurality of shift register groups comprises a plurality of shift registers, each of the plurality of shift registers is electrically connected to a corresponding pixel circuit through a data line;
at least one data input terminal electrically connected to a first stage shift register of each of the plurality of shift register groups; and
a plurality of clock lines, each of the plurality of clock lines being electrically connected to each shift register in a same one of the plurality of shift register groups.

2. The semiconductor device according to claim 1, wherein the plurality of clock lines are configured to transmit a plurality of clock signals having a same frequency and different phases respectively.

3. The semiconductor device according to claim 1, wherein the shift registers of the plurality of shift register groups are arranged alternately in sequence.

4. The semiconductor device according to claim 2, wherein a clock line of the plurality of clock lines for transmitting a clock signal with a more delayed phase is electrically connected to a shift register group of the plurality of shift register groups arranged further back.

5. The semiconductor device according to claim 1, wherein the plurality of shift register groups comprises a first shift register group and a second shift register group, and the at least one data input terminal is electrically connected to the first shift register group and the second shift register group; and
the plurality of clock lines comprises a first clock line and a second clock line, the first clock line is electrically connected to one of the first shift register group or the second shift register group, and the second clock line is electrically connected to another of the first shift register group or the second shift register group.

6. The semiconductor device according to claim 5, wherein the plurality of shift register groups comprises a first shift register and a second shift register arranged alternately in sequence, the first shift register group comprises the first shift register, and the second shift register group comprises the second shift register; and
the first clock line is electrically connected to the first shift register group, the second clock line is electrically connected to the second shift register group, the first clock line is configured to transmit a first clock signal, the second clock line is configured to transmit a second clock signal, and a phase of the second clock signal is delayed from a phase of the first clock signal.

7. The semiconductor device according to claim 6, wherein a frequency of the first clock signal is the same as a frequency of the second clock signal, and a difference between the phase of the first clock signal and the phase of the first clock signal is 180°.

8. The semiconductor device according to claim 1, wherein the source driver further comprises signal processing modules, an input terminal of each of the signal processing modules is electrically connected to an output terminal of a shift register of the shift registers, and each of the signal processing modules outputs a corresponding data signal.

9. The semiconductor device according to claim 8, wherein each of the signal processing modules comprises a latch, a level converter, a digital-to-analog converter, and an amplifier that is electrically connected in sequence, an input terminal of the latch is electrically connected to an output terminal of the shift register, a trigger terminal of the latch is electrically connected to a data enable line, and the amplifier is configured to output a corresponding data signal.

10. The semiconductor device according to claim 1, wherein at least one of the at least one data input terminal and the plurality of clock lines is disposed in the insulating substrate.

11. A display panel comprising the semiconductor device according to claim 1, wherein the data input terminal is configured to transmit a digital signal.

12. The display panel according to claim 11, wherein the plurality of clock lines are configured to transmit a plurality of clock signals having a same frequency and different phases respectively.

13. The display panel according to claim 11, wherein the shift registers of the plurality of shift register groups are arranged alternately in sequence.

14. The display panel according to claim 12, wherein a clock line of the plurality of clock lines for transmitting a clock signal with a more delayed phase is electrically connected to a shift register group of the plurality of shift register groups arranged further back.

15. The display panel according to claim 11, wherein the plurality of shift register groups comprises a first shift register group and a second shift register group, and the at least one data input terminal is electrically connected to the first shift register group and the second shift register group; and
the plurality of clock lines comprises a first clock line and a second clock line, the first clock line is electrically connected to one of the first shift register group or the second shift register group, and the second clock line is electrically connected to another of the first shift register group or the second shift register group.

16. The display panel according to claim 15, wherein the plurality of shift register groups comprises a first shift register and a second shift register arranged alternately in sequence, the first shift register group comprises the first shift register, and the second shift register group comprises the second shift register; and
the first clock line is electrically connected to the first shift register group, the second clock line is electrically connected to the second shift register group, the first clock line is configured to transmit a first clock signal, the second clock line is configured to transmit a second clock signal, and a phase of the second clock signal is delayed from a phase of the first clock signal.

17. The display panel according to claim 16, wherein a frequency of the first clock signal is the same as a frequency of the second clock signal, and a difference between the phase of the first clock signal and the phase of the first clock signal is 180°.

18. The display panel according to claim 11, wherein the source driver further comprises signal processing modules, an input terminal of each of the signal processing modules is electrically connected to an output terminal of a shift register of the shift registers, and each of the signal processing modules outputs a corresponding data signal.

19. The display panel according to claim 18, wherein each of the signal processing modules comprises a latch, a level converter, a digital-to-analog converter, and an amplifier that is electrically connected in sequence, an input terminal of the latch is electrically connected to an output terminal of the shift register, a trigger terminal of the latch is electrically connected to a data enable line, and the amplifier is configured to output a corresponding data signal.

20. The display panel according to claim 11, wherein at least one of the at least one data input terminal and the plurality of clock lines is disposed in the insulating substrate.
